# EUROPEAN PATENT SPECIFICATION

(11) **EP 2 828 416 B1**
(45) Date of publication and mention of the grant of the patent: **04.09.2019**
(21) Application number: 13764144.5
(22) Date of filing: 07.03.2013
(51) Int. Cl.: H01L 21/677, C23C 16/458, C23C 14/50, C23C 14/56

(54) **VAPOR DEPOSITION SYSTEM AND METHOD**
DAMPFABLAGERUNGSSYSTEM UND -VERFAHREN
SYSTÈME ET PROCÉDÉ DE DÉPÔT EN PHASE VAPEUR

(30) Priority: 20.03.2012 US 201261613366 P; 16.10.2012 US 201213653352
(43) Date of publication of application: 28.01.2015
(73) Proprietor: Quantum Innovations, Inc., Central Point, OR 97502 (US); Kester, Norman, L., Central Point, OR 97502 (US); Leidecker, Cliff, J., Central Point, OR 97502 (US)
(72) Inventor: KESTER, Norman, L., Central Point, OR 97502 (US); LEIDECKER, Cliff, J., Central Point, OR 97502 (US)
(74) Representative: Appleyard Lees IP LLP
(86) International application number: PCT/US2013/029605
(87) International publication number: WO 2013/142082

(56) References cited:
- DE-A1- 19 836 652
- US-A1- 2001 015 074
- US-A1- 2001 015 074
- US-A1- 2003 190 223
- US-A1- 2005 019 504
- US-A1- 2006 049 044
- US-A1- 2006 102 078
- US-A1- 2009 320 755
- US-A1- 2010 162 955
- US-A1- 2010 313 809
- US-A1- 2010 313 809

## Description

### FIELD OF THE INVENTION

The disclosure generally relates to coatings for optical lenses and other substrates. More particularly, the disclosure relates to a physical or chemical vapor, corona method, or thermal evaporation deposition system and method which facilitate sequential application of coatings to an optical lens or other substrate by gravity-actuated transfer of the substrates between successive deposition chambers.

### BACKGROUND OF THE INVENTION

Optical lenses of eyewear such as eyeglasses and sunglasses may include one or more optical coatings which impart a desired appearance or optical characteristic to the lenses. An optical coating includes one or multiple layers of material which are deposited on one or both sides of an optical lens and affects the manner in which the lens reflects and transmits light. Antireflective coatings and high-reflective coatings are examples of optical coatings which may be applied to an optical lens.

A common method of applying an optical coating to an optical lens includes dipping the lens in a solution which adheres to one or both surfaces of the lens upon removal of the lens from the solution and then curing the solution to form the coating. Another method of applying an optical coating to an optical lens involves applying the coating to one or both surfaces of the lens using a physical vapor deposition (PVD) process.

In some applications, it may be necessary or desirable to sequentially apply multiple layered coatings to one or both surfaces of an optical lens. For example, application of optical coatings to one or both surfaces of optical lenses for eyewear may include application of metallic, dielectric, dichroic, hydrophobic, oleophobic or super hydrophobic coatings to the lenses in a sequential manner. One challenge, which is inherent in the serial application of coatings to optical lenses, is the transfer of each lens among multiple deposition chambers in a manner which is both efficient and does not risk physical contact or contamination of the freshly-applied coatings on the lens.

Therefore, a physical vapor deposition (PVD) system which facilitates sequential application of coatings to an optical lens or other substrate by gravity-actuated transfer of the substrates between successive PVD chambers is needed.

US 2001/015074 discloses a consecutive deposition system

US 2010/313809 discloses a substrate processing system having an improved substrate transport system.

DE 198 36 652 A1 discloses a deposition system with a sloped transfer rail.

### SUMMARY OF THE INVENTION

The invention is directed to a deposition system according to claim 1 and a deposition method according to claim 12. An illustrative embodiment of the system includes a deposition system, comprising a system housing having a housing frame, housing panels carried by said housing frame and a housing interior, a fixture transfer assembly having a generally elongated sloped fixture transfer rail carried by the system frame and extending through the housing interior, a plurality of sequentially ordered deposition chambers carried by the fixture transfer rail in the housing interior, a controller interfacing with the deposition chambers, a plurality of circular fixture carrier assemblies carried by the fixture transfer rail and each adapted to contain one substrate, wherein the fixture carrier assemblies roll along the fixture transfer rail under influence of gravity.

### BRIEF DESCRIPTION OF THE DRAWINGS

The disclosure will now be made, by way of example, with reference to the accompanying drawings, in which:
FIG. 1 is a left side front perspective view of an illustrative embodiment of the vapor deposition system, with the system housing in an open configuration;
FIG. 2 is a right side front perspective view of an illustrative embodiment of the vapor deposition system, with the system housing in an open configuration;
FIG. 3 is a perspective view of an illustrative embodiment of the vapor deposition system, with the system housing in a closed configuration;
FIG. 4 is a perspective view of a film application system of an illustrative embodiment of the vapor deposition system;
FIG. 5 is a block diagram which illustrates interconnection of the various subsystem components of the physical vapor deposition system; and
FIG. 6 is a flow diagram of an illustrative embodiment of a physical vapor deposition method.

### DETAILED DESCRIPTION

The following detailed description is merely exemplary in nature and is not intended to limit the described embodiments or the application and uses of the described embodiments. As used herein, the word "exemplary" or "illustrative" means "serving as an example, instance, or illustration." Any implementation described herein as "exemplary" or "illustrative" is not necessarily to be construed as preferred or advantageous over other implementations. All of the implementations described below are exemplary implementations provided to enable persons skilled in the art to practice the disclosure and are not intended to limit the scope of the appended claims. Furthermore, there is no intention to be bound by any expressed or implied theory presented in the preceding technical field, background, brief summary or the following detailed description.

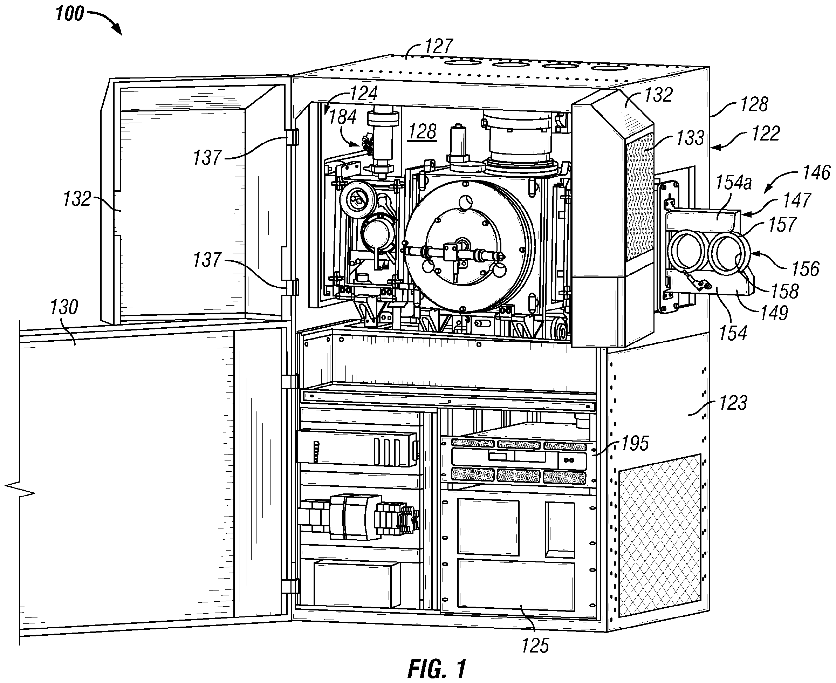

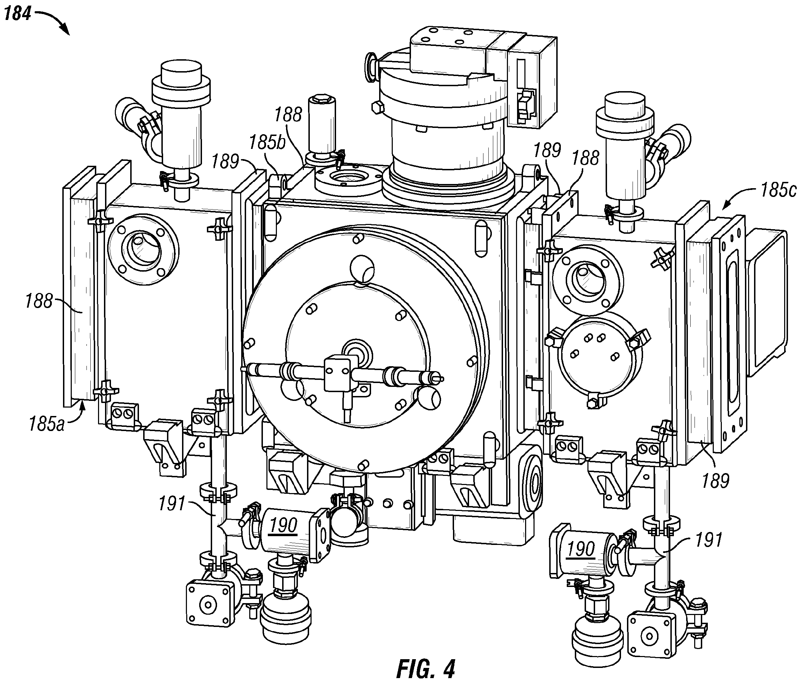

Referring initially to FIGS. 1-4 of the drawings, an illustrative embodiment of the physical vapor deposition system, hereinafter system, is generally indicated by reference numeral 100. As will be hereinafter further described, the system 100 is adapted to sequentially apply one or more coatings (not illustrated) on one or both surfaces (not illustrated) of a substrate (not illustrated) using a physical vapor deposition (PVD) process. In some applications, the substrate may be an optical lens of eyewear such as eyeglasses or sunglasses, for example and without limitation. The coating(s) which is/are applied to the substrate may be hydrophobic, oleophobic or super hydrophobic coatings, for example and without limitation, which may serve as antireflective coatings, high-reflector coatings or other optical coatings known in the art. The PVD processes which are used to apply the coatings to the substrate may be sequentially carried out in a series of multiple processing chambers 185 (FIG. 4). Each substrate may be transferred from one processing chamber 185 to the next processing chamber 185 in the deposition process via gravity, as will be hereinafter further described.

The system 100 may include a system housing 122. In some embodiments, the system housing 122 may include a pair of side housing panels 123, a top housing panel 127 and a rear housing panel 128 which define a housing interior 124. The housing interior 124 may be divided into a lower subsystem compartment 125 and an upper chamber compartment 126. The subsystem compartment 125 may contain various subsystem components of the system 100 which will be hereinafter described. The chamber compartment 126 may contain a film application system 184 having multiple processing chambers 185. In operation of the system 100, which will be hereinafter described, the processing chambers 185 implement etching and physical vapor deposition functions in the processing of substrates.

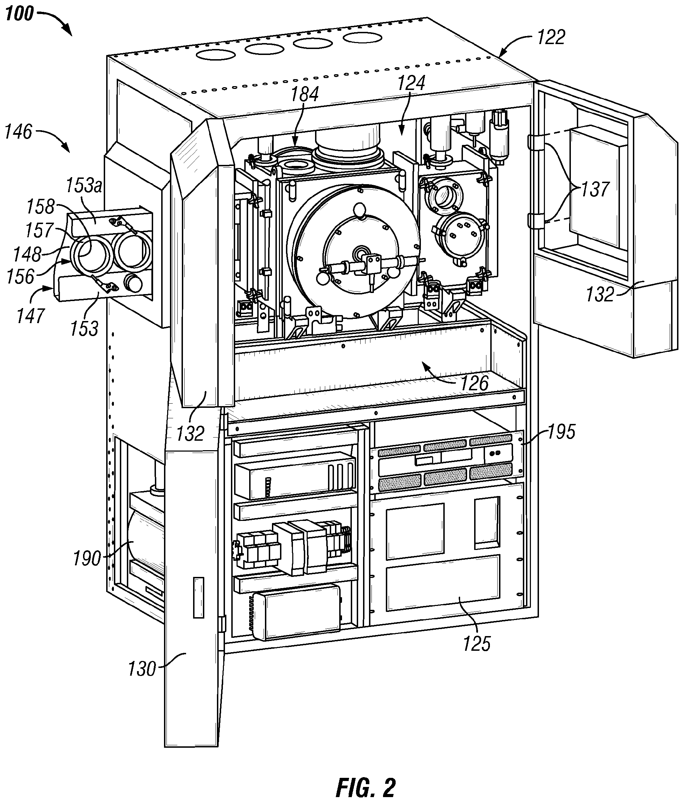

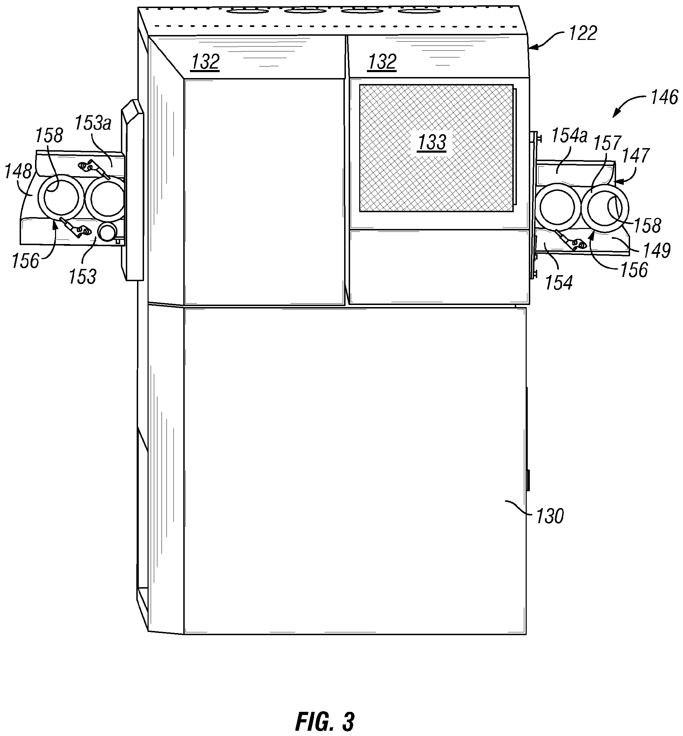

As illustrated in FIGS. 1-4, the system housing 122 may include at least one front subsystem compartment door 130 provided on the system frame 101. In some embodiments, the system housing 122 may have multiple, adjacent front subsystem compartment doors 130. The front subsystem compartment doors 130 may be selectively opened to expose the subsystem compartment 125 at the front portion of the housing interior 124, as illustrated in FIGS. 1 and 2, or selectively closed to conceal the subsystem compartment 125 at the front portion of the housing interior 124, as illustrated in FIG. 3.

In some embodiments, the system housing 122 may further include at least one rear subsystem compartment door (not illustrated) provided on the system housing 122. The rear subsystem compartment door may be selectively opened to expose the subsystem compartment 125 at the rear portion of the housing interior 124 or selectively closed to conceal the subsystem compartment 125 at the rear portion of the housing interior 124.

The system housing 122 may include at least one front chamber compartment door 132 to selectively expose and conceal the chamber compartment 126 at the front portion of the housing interior 124. At least one of the front chamber compartment doors 132 may have at least one window 133. In some embodiments, the front chamber compartment door 132 may be pivotally attached to a side housing panel 123 of the system housing 122 via door hinges 137 (FIGS. 1 and 2). At least one door latch (not illustrated) may be provided on each front chamber compartment door 132. The door latch or latches may be adapted to selectively lock the front chamber compartment door or doors 132 in the closed position of FIG. 3 or selectively unlock the front chamber compartment door or doors 132 for opening as illustrated in FIGS. 1 and 2. In some embodiments, at least one door extension cylinder (not illustrated) may be attached to the system housing 122. A door extension piston (not illustrated) may be extendable from the door extension cylinder. The door extension piston may be attached to an interior surface of the front chamber compartment door 132. Accordingly, when the front chamber compartment door 132 is closed and the door latch (not illustrated) is latched, the door extension piston is retracted into the door extension cylinder. When the front chamber compartment door 132 is open, the door extension piston extends from the door extension cylinder and maintains the front chamber compartment door 132 in the open position.

In some embodiments, the system housing 122 may further include a rear chamber compartment door (not illustrated) to selectively expose and conceal the chamber compartment 126 at the rear portion of the housing interior 124. The rear chamber compartment door may have a design and attachment which are as were heretofore described with respect to the front chamber compartment door or doors 132.

As further illustrated in FIGS. 1-6, the system 100 may include a fixture transfer assembly 146. The fixture transfer assembly 146 may include a generally elongated fixture transfer rail 147 which extends transversely through the chamber compartment 126 of the housing interior 124 in the system housing 122. The fixture transfer rail 147 may have a fixture loading end 148 and a fixture unloading end 149. A lower loading ramp segment 153 and an upper loading ramp segment 153a, and a lower unloading ramp segment 154 and an upper unloading ramp segment 154a, of the fixture transfer rail 147 may protrude beyond the respective loading and unloading ends, respectively, of the system housing 122. The fixture transfer rail 147 may generally slope downwardly from the fixture loading end 148 to the fixture unloading end 149.

The fixture transfer rail 147 of the fixture transfer assembly 146 may be mounted in the chamber compartment 126 of the housing interior 124 according to any suitable technique which is known by those skilled in the art. In some embodiments, the fixture transfer assembly 146 may include a generally elongated chamber support member (not illustrated) which extends through the chamber compartment 126 in generally transverse relationship to the longitudinal axis of the system housing 122. The chamber support member may be attached to any structural component of the system housing 122 using welding, fasteners and/or other suitable attachment technique. The fixture transfer rail 147 may be sloped with respect to the horizontal at a slope angle of about 91.50 degrees.

As illustrated in FIGS. 1-3, the fixture transfer assembly 146 may further include at least one fixture carrier assembly 156. In some embodiments, the fixture transfer assembly 146 may include multiple fixture carrier assemblies 156, as illustrated. Each fixture carrier assembly 156 may include an annular assembly frame 157 having a frame opening 158. A fixture mount plate (not illustrated) having a fixture opening may be provided in the frame opening 158. The fixture opening is sized and configured to receive and secure a single substrate (not illustrated) typically in the conventional manner.

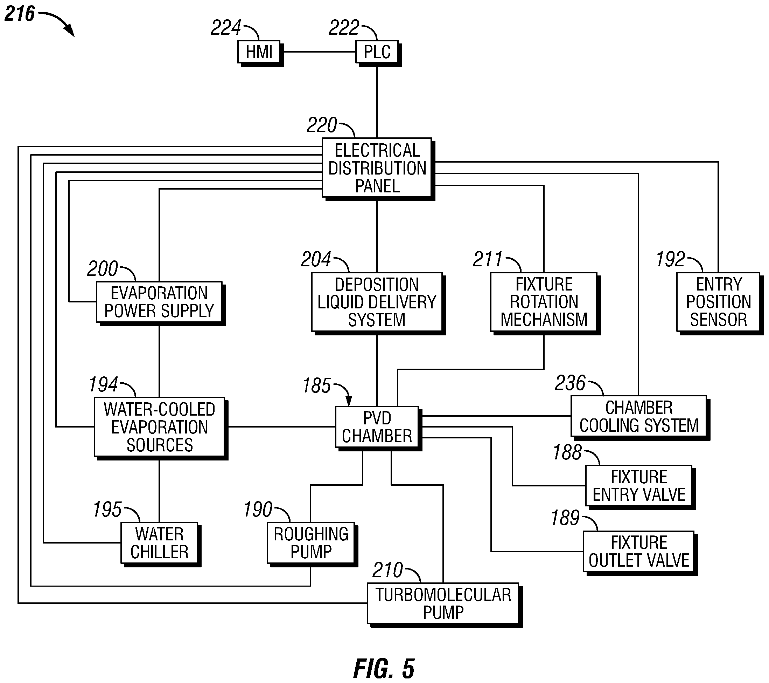

As illustrated in FIGS. 1 and 2 of the drawings, a film application system 184 having multiple processing chambers 185 (FIG. 4) is provided in the chamber compartment 126 of the housing interior 124. The processing chambers 185 have physical vapor deposition capabilities according to the knowledge of those skilled in the art. At least one of the processing chambers 185 may have substrate etching capabilities. As illustrated in FIG. 5, in some embodiments, the processing chambers 185 may include a first processing chamber 185a, a second processing chamber 185b and a third processing chamber 185c which are sequentially ordered between the lower and upper loading ramp segments 153, 153a on one side and the lower and upper unloading ramp segments 154, 154a on the other side of the system housing 122. Therefore, the processing chambers 185 may assume the sloped or angled orientation of the fixture transfer rail 147.

Each processing chamber 185 is adapted to receive by gravity and contain a fixture carrier assembly 156 having a substrate (not illustrated) retained therein for processing of the substrate. As illustrated in FIG. 4, a fixture entry valve 188 may be disposed in fluid communication with each processing chamber 185 at an inlet side of the processing chamber 185. A fixture outlet valve 189 may be disposed in fluid communication with the processing chamber 185 at an outlet side of the processing chamber 185. The fixture entry valves 188 and the fixture outlet valves 189 may couple the first processing chamber 185a to the second processing chamber 185b and the second processing chamber 185b to the third processing chamber 185c with a vacuum-tight seal in the chamber compartment 126 of the housing interior 124. In operation of the system 100, which will be hereinafter further described, the fixture entry valve 188 and the fixture outlet valve 189 may facilitate sequential transfer of each of multiple fixture carrier assemblies 156 into and out of, respectively, each processing chamber 185.

As further illustrated in FIG. 4, the film applicator system 184 may include a roughing pump 190 which is disposed in fluid communication with each processing chamber 185 through a roughing pump conduit 191. Multiple water-cooled evaporation sources (not illustrated) may be provided in each processing chamber 185. A water chiller (not illustrated) may be connected to the water-cooled evaporation sources through a pair of water hoses. An evaporation power supply (not illustrated) may be electrically connected to the water-cooled evaporation sources through a pair of power cables.

At least one liquid delivery injection arm (not illustrated) may be disposed in fluid communication with each processing chamber 185. In some embodiments, a pair of front and rear liquid delivery injection arms may be disposed in fluid communication with each processing chamber 185. An arm internalization mechanism (not illustrated) may engage each liquid delivery injection arm for internalization of the liquid delivery injection arms through respective front and back side liquid delivery ports (not illustrated) into the processing chamber 185 in operation of the system 100. When in the internalized configuration, the liquid delivery injection arms may be positioned on opposite front and back sides of the fixture carrier assembly 156. A deposition liquid delivery system (not illustrated) may be disposed in fluid communication with the liquid delivery injector arms through liquid delivery lines.

A turbomolecular pump (not illustrated) may be disposed in fluid communication with each processing chamber 185. Each processing chamber 185 may include a fixture rotation mechanism (not illustrated) which facilitates rotation of the fixture carrier assembly 156 in the processing chamber 185. The fixture rotation mechanism may include a movement sensor (not illustrated) which senses movement of the fixture carrier assembly 156 in the processing chamber 185. A vacuum valve (not illustrated) may be disposed in fluid communication with the processing chamber 185 in communication with the turbomolecular pump.

It will be recognized and understood that the foregoing description of each processing chamber 185 is a general description and it will be recognized and understood that processing chambers of various design which are known by those skilled in the art may be suitable for the purpose of etching and depositing coatings on substrates using physical vapor deposition techniques in operation of the system 100. Some processing chambers 185 which are suitable for implementation of the system 100 may depart in at least some design details from the foregoing description of the processing chamber 185 which was set forth herein above with respect to FIG. 4. At least one of the processing chambers 185 may have any etching chamber design with necessary hardware which is suitable for etching and cleaning of the substrates preparatory to deposition of coatings on the substrates by operation of the processing chambers 185. Etching chamber designs are well-known by those skilled in the art; therefore, the hardware and design of the etching chamber 198 need not be set forth herein in detail. Generally, the etching chamber may include a fixture entry valve 188 and a fixture outlet valve 189 which facilitate entry and exit of individual fixture carrier assemblies 156 into and out of, respectively, the etching chamber, as was heretofore described with respect to the processing chambers 185 in FIG. 4.

Referring next to FIG. 5 of the drawings, a block diagram of a control system 216 which is suitable for implementation of the physical vapor deposition system 100 is illustrated. The control system 216 may include a programmable logic controller (PLC) 222. A human-machine interface (HMI) 224 may interface with the PLC 222. The HMI 224 may include a keyboard, mouse and/or other elements which may be used to program the PLC 222 to operate the multiple functions of the system 100. An electrical distribution panel 220 may interface with the PLC 222. The various functional components of the system 100 may be electrically connected to the electrical distribution panel 220. Accordingly, the PLC 222 may be adapted to operate the various subsystems of the system 200 through the electrical distribution panel 220.

Some of the subsystems of the system 100 may include a roughing pump 190, water-cooled evaporation sources 194, a deposition liquid delivery system 204, a fixture rotation mechanism 211, a fixture entry valve 188, a fixture outlet valve 189 and a turbomolecular pump 210, each of which is disposed inside or interfaces with the processing chamber 185. The evaporation power supply 200 may be electrically connected to the electrical distribution panel 220 and the water-cooled evaporation sources 194 in the processing chamber 185. The water chiller 195 may be electrically connected to the electrical distribution panel 220 and disposed in fluid communication with the water-cooled evaporation sources 194. In some embodiments, an entry position sensor 192 may be connected to the electrical distribution panel 220 and disposed at the entry position of the processing chamber 185 adjacent to the fixture entry valve 188. The entry position sensor 192 may be adapted to sense the fixture carrier assembly 156 at the entry position of the processing chamber 185 and enable the PLC 222 to open the fixture entry valve 188 of the processing chamber 185 for entry of the fixture carrier assembly 156 into the processing chamber 185, as will be hereinafter described. As further illustrated in FIG. 5, in some embodiments, a chamber cooling system 236 may interface with each processing chamber 185 and the electrical distribution panel 220 for the purpose of cooling the interior of the processing chamber 185.

Some of the subsystems of the system 100 may be contained in the subsystem compartment 125 (FIGS. 1 and 2) of the housing interior 124. In some embodiments, the roughing pumps 190, the water chiller 195 and the evaporation power supply 200 may be contained in the subsystem compartment 125 in the front portion of the housing interior 124. The electrical distribution panel 220 and the PLC 222 may be contained in the subsystem compartment 125 in the rear portion of the housing interior 124. The subsystems can be selectively exposed and accessed for repair, replacement and/or maintenance purposes by opening the front subsystem compartment doors 130 (FIG. 1) and the rear subsystem compartment door (not illustrated). Likewise, the PVD chambers 185 can be selectively exposed and accessed for repair, replacement and/or maintenance purposes by opening the front chamber compartment door 132 and the rear chamber compartment door (not illustrated).

In exemplary application, the system 100 is operated to apply one or multiple coatings (not illustrated) to one or both sides of a substrate (not illustrated) in a sequential manner using a physical vapor deposition (PVD) process. In some applications, the substrate may be an optical lens which will be used in the assembly of eyewear such as eyeglasses or sunglasses, for example and without limitation. For example and without limitation, in some applications, the system 100 may be operated to plasma etch the front and backsides of an optic lens; apply a mirror coating to the front of the lens; and apply an oleophobic/hydrophobic coating to the front and backside of the lens. In other applications, the substrate may be any type of substrate to which one or more coatings is to be applied using a PVD process.

A substrate is secured in each of multiple fixture carrier assemblies 156 (FIGS. 1-3). As will be hereinafter further described, each fixture carrier assembly 156 serves as a vehicle for transport of the substrate between and within the sequential processing chambers 185. Accordingly, each substrate may initially be secured in the frame opening 158 of a corresponding fixture carrier assembly 156.

As illustrated in FIGS. 2 and 3, at least one fixture carrier assembly 156 (each containing a substrate 182 held therein) is initially placed on the lower loading ramp segment 153 of the fixture transfer rail 147. In some embodiments, multiple fixture carrier assemblies 156 may be placed in series on the lower loading ramp segment 153 of the fixture transfer rail 147, as illustrated. Each fixture carrier assembly 156 may be inserted in place between the lower loading ramp segment 153 and the upper loading ramp segment 153a such that a circumferential rail groove (not illustrated) in the assembly frame 157 of the fixture carrier assembly 156 receives the lower loading ramp segment 153 and the upper loading ramp segment 153a of the fixture transfer rail 147. Therefore, each fixture carrier assembly 156 is self-standing between the lower loading ramp segment 153 and the upper loading ramp segment 153a.

Due to the angled or sloped configuration of the lower loading ramp segment 153 and the upper loading ramp segment 153a, each fixture carrier assembly 156 has a tendency to roll under influence of gravity on the fixture transfer rail 147 from the fixture loading end 148 toward the fixture unloading end 149 thereof. Accordingly, the fixture carrier assembly 156 which is first in the series of multiple fixture carrier assemblies 156 on the loading ramp segment 153 rolls to a "ready" position adjacent to a fixture entry valve 188 at the inlet of the first processing chamber 185a. A second fixture carrier assembly 156 rolls into the space which was previously occupied by the first fixture carrier assembly 156, and the remaining fixture carrier assemblies 156 roll into the spaces previously occupied by the preceding fixture carrier assemblies 156, respectively.

The system 100 is initialized and enters a standby condition as the PLC 222 (FIG. 5) is turned on. The operational parameters (temperature, pressure, etc.) for the etching process which is to be carried out and for each of the deposition processes which are to be sequentially carried out in the processing chambers 185 may be programmed into the PLC 222 (FIG. 5) through the HMI 224. An entry position sensor (not illustrated) at the "ready" position adjacent to the fixture entry valve 188 of the first processing chamber 185a senses the location of the first fixture carrier assembly 156 at the "ready" position and transmits a signal to the PLC 222. In response, the PLC 222 opens the fixture entry valve 188 of the first processing chamber 185a and the first fixture carrier assembly 156 rolls into the first processing chamber 185a. The PLC 222 then closes the fixture entry valve 188 of the first processing chamber 185a and establishes the programmed pressure in the first processing chamber 185a. The next fixture carrier assembly 156 in line on the unloading ramp segment 154 rolls on the fixture transfer rail 147 under the influence of gravity into the "ready" position next to the fixture entry valve 188 of the first processing chamber 185.

After the PLC 222 establishes the etching temperature, pressure and other operational parameters which were preprogrammed into the PLC 222, the first processing chamber 185a, under control by the PLC 222, may operate to etch and clean both surfaces of each substrate which is held in the first fixture carrier assembly 156. After etching and cleaning of the substrates in the first fixture carrier assembly 156 is completed, the PLC 222 opens a fixture outlet valve 189 of the first processing chamber 185 and the first fixture carrier assembly 156 rolls from the first processing chamber 185 into the entry position of the second processing chamber 185b. The entry position sensor 192 (FIG. 5) senses that the first fixture carrier assembly 156 is at the entry position of the second processing chamber 185b and transmits a signal to the PLC 222 indicating the entry position of the first fixture carrier assembly 156. In response, the PLC 222 vents the first processing chamber 185a to atmosphere and then opens the fixture entry valve 188 of the second processing chamber 185b. Simultaneously, the front and back side liquid delivery ports (not illustrated) of the second processing chamber 185b are opened and the front and rear liquid delivery injector arms (not illustrated), under actuation by the arm internalization mechanisms (not illustrated), descend into the second processing chamber 185b. The first fixture carrier assembly 156 rolls into place in the second processing chamber 185b. The PLC 222 then closes the fixture entry valve 188. The PLC 222, responsive to input from the entry sensor (not illustrated) at the "ready" position of the first processing chamber 185a, opens the fixture entry valve (not illustrated) of the first processing chamber 185a and the fixture carrier assembly 156 which was next in line behind the first fixture carrier assembly 156 rolls on the fixture transfer rail 147 into the first processing chamber 185a.

The deposition liquid (not illustrated) which will form the coatings on one or both surfaces of each substrate in the first fixture carrier assembly 156 is dispensed from the deposition liquid delivery system 204 (FIG. 5) through the respective liquid delivery lines (not illustrated) to the liquid delivery injector arms (not illustrated). The liquid delivery injector arms dispense the deposition liquid into the water-cooled evaporation sources 194 (FIG. 5) in the second processing chamber 185b. Once the deposition liquid is fully dispensed into the evaporation sources 194, the liquid delivery injector arms are retracted from the second processing chamber 185b and the liquid delivery ports (not illustrated) are closed. Next, the fixture rotation mechanism 211 (FIG. 5) may rotate the first fixture carrier assembly 156 in the second processing chamber 185b and the PLC 222 pulls vacuum on the second processing chamber 185b via the roughing pump 190 and the turbomolecular pump. Once the correct level of vacuum pressure in the second processing chamber 185b has been achieved, the deposition liquid in the evaporation sources 194 is evaporated into the second processing chamber 185b, coating the substrate in the first fixture carrier assembly 156. After it determines that a predetermined period of time has elapsed to ensure thorough coating of the substrates, the PLC 222 vents the second processing chamber 185b to atmosphere. The PLC 222 then opens the fixture outlet valve 189 of the second processing chamber 185b such that the first fixture carrier assembly 156 rolls under influence of gravity the second processing chamber 185b to the fixture entry position of the third processing chamber 185c. The same PVD and transfer process is then carried out on the substrates of the first fixture carrier assembly 156 in the third processing chamber 185d until the desired coatings have been sequentially applied to the surfaces of each substrate. As the PVD process is carried out in the second processing chamber 185b, the substrates held in the fixture carrier assembly 156 which was next in line behind the first fixture carrier assembly 156 may be etched in the first processing chamber 185a. The substrates in that next-in-line fixture carrier assembly 156 may then be subjected to the PVD processes in the second processing chamber 185b and the third processing chamber 185c in the same manner as the substrates in the first fixture carrier assembly 156.

After the PVD processes in the third processing chamber 185c are completed, the fixture carrier assemblies 156 sequentially roll from the third processing chamber 185c onto the unloading ramp segment 154 of the fixture transfer rail 147. The fixture carrier assemblies 156 are removed from the unloading ramp segment 154 and the substrates are removed from the frame openings 158 in the fixture carrier assemblies 156 for further processing. Between uses of the system 100, the PLC 222 may periodically operate the chamber cooling system 236 (FIG. 5) to clean the interior of each processing chamber 185 as deemed necessary.

It will be appreciated by those skilled in the art that the physical vapor deposition system 100 is capable of processing substrates in multiple fixture carrier assemblies 156 at the same time by simultaneous operation of the processing chambers 185. This expedient facilitates high-speed, low-volume and high-throughput production of thin film-coated substrates using physical vapor deposition processes. Moreover, transfer of the fixture carrier assemblies 156 between the processing chambers 185 by gravity eliminates the need for mechanical structure and related power supply which would otherwise be required for the transfer operation. The system 100 may be designed such that the chamber functions and capabilities are flexible and can be adapted for various types of physical vapor deposition applications on different types of substrates. Examples include but are not limited to ophthalmic mirror coatings, ophthalmic anti-reflective coatings, protective coatings, cosmetic coatings, compact disc manufacturing and medical device manufacturing. The construction methods and materials for the system 100 may be tailored according to the particular thin films which are to be applied to the substrates. The system 100 may be constructed in any of various sizes depending on the desired application. Various alternative designs for the subsystems, assemblies and components may be used in various embodiments of the system 100. The system 100 may be fabricated using a variety of fabrication techniques including but not limited to welding, brazing, connectors, terminal blocks, screws, bolts, nuts and clamps.

It will be further appreciated by those skilled in the art that each processing chamber 185 may contain multiple water-cooled evaporation sources 194 (FIG. 5) to enhance the flexibility of the physical vapor deposition system 100. Thus, multiple types of physical vapor deposition by evaporation processes can be carried out in each processing chamber 185. The system housing 122 may be fabricated with a small footprint to facilitate ease and space efficiency in placement of the physical vapor deposition system 100 in retail locations.

Various structural provisions instead of or in addition to those which were heretofore described with respect to the drawings may be made for the functioning and distribution of the vacuum subsystem, pneumatic subsystem, electrical subsystem and/or any other subsystems or components which may be deemed necessary for operation of the processing chambers 185 or any other operational component or subsystem of the system 100. For example and without limitation, vacuum system conduits (not illustrated) may be routed throughout the housing interior 124 to provide connection between the roughing pumps 190, turbomolecular pumps and/or other pumps and the processing chambers 185. Pneumatic system conduits (not illustrated) may provide connection between vacuum subsystem components or pneumatic subsystem components and the processing chambers 185. Pneumatic system ports (not illustrated) may be provided in the fixture transfer rail 147 and/or other structural components of the system 100 for functioning of the pneumatic subsystem. Other structural provisions may include whichever supports, wiring and plumbing may be necessary to interconnect all components and subsystems.

The film applicator system 184 (FIG. 17) of the system 100 may be designed as a stand-alone unit, as part of an in-line physical vapor deposition system or as part of a larger, more complex system. The film applicator system 184 can coat one side or two sides of a substrate and a two-sided coating applied to the substrate may be performed individually or simultaneously at high speeds and high throughput. The film applicator system 184 may be operated manually, semi-automatically or fully automatically via a computer or the PLC 222 and HMI 224 (FIG. 5).

The fixture carrier assemblies 156 may be constructed of various materials depending on the particular application. The fixture carrier assemblies 156 may be constructed for single-side application and may be fabricated in various sizes. Alternative methods of holding the substrate in the frame opening 158 of each fixture carrier assembly 156 may be used. Moreover, the design of each fixture carrier assembly 156, as well as each processing chamber 185 as described and illustrated herein, may facilitate uniform coating of either or both surfaces of each substrate depending on the desired application.

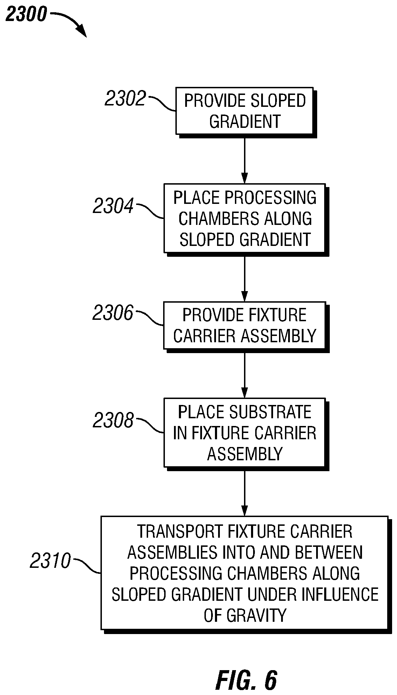

Referring next to FIG. 6 of the drawings, a flow diagram 2300 of an illustrative embodiment of a physical vapor deposition method is illustrated. In block 2302, a sloped gradient is provided. In block 2304, processing chambers are placed along the sloped gradient. In some applications, the processing chambers may include an etching chamber and at least one physical vapor deposition (PVD) chamber. In some embodiments, the processing chambers may include an etching chamber and multiple sequentially-ordered PVD chambers. In block 2306, at least one fixture carrier assembly is provided. In block 2308, a substrate is placed in the fixture carrier assembly. In block 2310, the fixture carrier assemblies are transported into and between the processing chambers along the sloped gradient under the influence of gravity. The design of each PVD chamber and each fixture carrier assembly may facilitate uniform deposition of one or more coatings on either or both surfaces of each substrate.

While various illustrative embodiments of the disclosure have been described above, it will be recognized and understood that various modifications can be made in the disclosure and the appended claims are intended to cover all such modifications which may fall within the scope of the embodiments of the disclosure.

## Claims

1. A deposition system (100), comprising:
a system housing (122) having a housing frame, housing panels (123, 127, 128) carried by said housing frame and a housing interior (124);
a fixture transfer assembly (146) having a generally elongated sloped fixture transfer rail (147) carried by the system frame and extending through the housing interior;
a plurality of sequentially ordered deposition chambers (185) carried by the fixture transfer rail in the housing interior;
a controller (222) interfacing with the deposition chambers;
a plurality of circular fixture carrier assemblies (156) carried by the fixture transfer rail and each adapted to contain one substrate; and
wherein the fixture carrier assemblies roll along the fixture transfer rail under influence of gravity.

2. The deposition system (100) of claim 1 wherein the fixture transfer rail (147) of the fixture
transfer assembly (146) comprises a loading ramp segment (153, 153a) and an unloading ramp segment (154, 154a) extending from the housing interior (124) at opposite sides of the system housing (122).

3. The deposition system (100) of claim 1 wherein the system housing (122) comprises at
least one entry.

4. The deposition system (100) of claim 1 wherein the housing interior (124) of the system
housing (122) comprises a subsystem compartment (125) and a chamber compartment (126), and wherein the deposition chambers are contained in the chamber compartment.

5. The deposition system of claim 4 wherein the system housing (122) comprises at least one
subsystem compartment door (130) adapted to selectively open and close the subsystem compartment (125) and at least one chamber compartment entry adapted to selectively open and close the chamber compartment.

6. The deposition system (100) of claim 5 wherein the at least one subsystem compartment
entry comprises first and second subsystem compartment doors (130) and the at least one chamber compartment entry comprises first and second chamber compartment entry.

7. The deposition system (100) of claim 1 wherein each of the fixture carrier assemblies (156)
comprises a circular assembly frame (157); or further comprising a fixture opening in the fixture mount plate and wherein the substrate is contained in the fixture opening; or wherein each of the substrate fixtures comprises a fixture frame having a fixture frame opening sized to receive a substrate; or further comprising a circumferential rail groove in the assembly frame (157) and receiving the fixture transfer rail (147) of the fixture transfer assembly (146); or wherein the fixture transfer rail (147) of the fixture transfer assembly (146) comprises a loading ramp segment (153, 153a) and an unloading ramp segment (154, 154a) extending from the housing interior (124) at opposite sides of the system housing (122); or further comprising a chamber cooling system (236) interfacing with each of the physical vapor deposition chambers (185) and the controller (222).

8. The deposition system (100) of claim 1 further comprising a human-machine interface (224)
interfacing with the controller (222).

9. The deposition system (100) according to claim 1, further comprising:
a generally square system housing (122) with a subsystem compartment (125) and a chamber compartment (126);
the fixture transfer assembly (146) extending generally through the chamber compartment (126) of the housing interior;
the plurality of sequentially ordered deposition chambers (185) carried by the fixture transfer rail (147) in the chamber compartment of the housing interior;
a programmable logic controller (222) interfacing with the etching chamber (198) and the physical vapor deposition chambers;
a human-machine interface interfacing with the programmable logic controller;
each of the fixture carrier assemblies including:
a circular assembly frame;
a fixture mount plate carried by the assembly frame;
a single fixture opening in the fixture mount plate;
a circumferential rail groove in the assembly frame and receiving the fixture transfer rail of the fixture transfer assembly; and
wherein the fixture carrier assemblies are transferred between the etching chamber and the deposition chambers under influence of gravity.

10. The deposition system (100) of claim 9 wherein each of the substrate fixtures comprises a
fixture frame having a fixture frame opening sized to receive a substrate.

11. The deposition system (100) of claim 9 wherein each of the deposition chambers (185) is
adapted to apply at least one coating to each of opposite surfaces of the substrate.

12. A deposition method, comprising:
providing a sloped fixed transfer rail;
providing a plurality of deposition chambers along the sloped fixed transfer rail;
providing a circular fixture carrier assembly adapted to contain at least one substrate;
placing the at least one substrate in the fixture carrier assembly; and
rolling the fixture carrier assemblies into and between the deposition chambers along the sloped fixture transfer rail under influence of gravity.

## Patentansprüche

1. Abscheidungssystem (100), welches umfasst:
ein Systemgehäuse (122), das einen Gehäuserahmen, Gehäuseplatten (123, 127, 128), die von dem Gehäuserahmen getragen werden, und ein Gehäuseinneres (124) aufweist;
eine Haltevorrichtungs-Transferanordnung (146), die eine im Wesentlichen lang gestreckte, geneigte Haltevorrichtungs-Transferschiene (147) aufweist, die von dem Systemrahmen getragen wird und sich durch das Gehäuseinnere hindurch erstreckt;
mehrere der Reihe nach angeordnete Abscheidungskammern (185), die von der Haltevorrichtungs-Transferschiene im Gehäuseinneren getragen werden;
eine Steuereinheit (222), die mit den Abscheidungskammern eine Schnittstelle bildet;
mehrere kreisförmige Haltevorrichtungs-Trägeranordnungen (156), die von der Haltevorrichtungs-Transferschiene getragen werden und jeweils dafür ausgelegt sind, ein Substrat zu enthalten; und
wobei die Haltevorrichtungs-Trägeranordnungen unter dem Einfluss der Schwerkraft auf der Haltevorrichtungs-Transferschiene entlangrollen.

2. Abscheidungssystem (100) nach Anspruch 1, wobei die Haltevorrichtungs-Transferschiene (147) der Haltevorrichtungs-Transferanordnung (146) ein Laderampensegment (153, 153a) und ein Entladerampensegment (154, 154a) umfasst, die sich vom Gehäuseinneren (124) aus auf gegenüberliegenden Seiten des Systemgehäuses (122) erstrecken.

3. Abscheidungssystem (100) nach Anspruch 1, wobei das Systemgehäuse (122) wenigstens einen Eingang umfasst.

4. Abscheidungssystem (100) nach Anspruch 1, wobei das Gehäuseinnere (124) des Systemgehäuses (122) ein Teilsystemabteil (125) und ein Kammerabteil (126) umfasst und wobei die Abscheidungskammern in dem Kammerabteil enthalten sind.

5. Abscheidungssystem nach Anspruch 4, wobei das Systemgehäuse (122) wenigstens eine Teilsystemabteiltür (130), die dafür ausgelegt ist, das Teilsystemabteil (125) selektiv zu öffnen und zu schließen, und wenigstens einen Kammerabteileingang, der dafür ausgelegt ist, das Kammerabteil selektiv zu öffnen und zu schließen, umfasst.

6. Abscheidungssystem (100) nach Anspruch 5, wobei der wenigstens eine Teilsystemabteileingang eine erste und eine zweite Teilsystemabteiltür (130) umfasst und der wenigstens eine Kammerabteileingang einen ersten und einen zweiten Kammerabteileingang umfasst.

7. Abscheidungssystem (100) nach Anspruch 1, wobei jede der Haltevorrichtungs-Trägeranordnungen (156) einen kreisförmigen Anordnungsrahmen (157) umfasst; oder ferner eine Haltevorrichtungsöffnung in der Haltevorrichtungs-Montageplatte umfasst, und wobei das Substrat in der Haltevorrichtungsöffnung enthalten ist; oder wobei jede der Substrathaltevorrichtungen einen Haltevorrichtungsrahmen umfasst, der eine Haltevorrichtungsrahmenöffnung aufweist, die dafür bemessen ist, ein Substrat aufzunehmen; oder ferner eine Umfangsschienennut in dem Anordnungsrahmen (157) umfasst, welche die Haltevorrichtungs-Transferschiene (147) der Haltevorrichtungs-Transferanordnung (146) aufnimmt; oder wobei die Haltevorrichtungs-Transferschiene (147) der Haltevorrichtungs-Transferanordnung (146) ein Laderampensegment (153, 153a) und ein Entladerampensegment (154, 154a) umfasst, die sich vom Gehäuseinneren (124) aus auf gegenüberliegenden Seiten des Systemgehäuses (122) erstrecken; oder ferner ein Kammerkühlsystem (236) umfasst, das mit jeder der Kammern zur physikalischen Dampfphasenabscheidung (185) sowie der Steuereinheit (222) eine Schnittstelle bildet.

8. Abscheidungssystem (100) nach Anspruch 1, welches ferner eine Mensch-Maschine-Schnittstelle (224) umfasst, die mit der Steuereinheit (222) eine Schnittstelle bildet.

9. Abscheidungssystem (100) nach Anspruch 1, welches ferner umfasst:
ein im Wesentlichen quadratisches Systemgehäuse (122) mit einem Teilsystemabteil (125) und einem Kammerabteil (126);
die Haltevorrichtungs-Transferanordnung (146), die sich im Wesentlichen durch das Kammerabteil (126) des Gehäuseinneren erstreckt;
die mehreren der Reihe nach angeordneten Abscheidungskammern (185), die von der Haltevorrichtungs-Transferschiene (147) im Kammerabteil des Gehäuseinneren getragen werden;
eine speicherprogrammierbare Steuerung (222), die eine Schnittstelle mit der Ätzkammer (198) und den Kammern zur physikalischen Dampfphasenabscheidung bildet;
eine Mensch-Maschine-Schnittstelle, die eine Schnittstelle mit der speicherprogrammierbaren Steuerung bildet;
wobei jede der Haltevorrichtungs-Trägeranordnungen aufweist:
einen kreisförmigen Anordnungsrahmen;
eine Haltevorrichtungs-Montageplatte, die von dem Anordnungsrahmen getragen wird;
eine einzige Haltevorrichtungsöffnung in der Haltevorrichtungs-Montageplatte;
eine Umfangsschienennut in dem Anordnungsrahmen, welche die Haltevorrichtungs-Transferschiene der Haltevorrichtungs-Transferanordnung aufnimmt; und
wobei ein Transfer der Haltevorrichtungs-Trägeranordnungen zwischen der Ätzkammer und den Abscheidungskammern unter dem Einfluss der Schwerkraft stattfindet.

10. Abscheidungssystem (100) nach Anspruch 9, wobei jede der Substrathaltevorrichtungen einen Haltevorrichtungsrahmen umfasst, der eine Haltevorrichtungsrahmenöffnung aufweist, die dafür bemessen ist, ein Substrat aufzunehmen.

11. Abscheidungssystem (100) nach Anspruch 9, wobei jede der Abscheidungskammern (185) dafür ausgelegt ist, auf jede der gegenüberliegenden Flächen des Substrats wenigstens eine Beschichtung aufzubringen.

12. Abscheidungsverfahren, welches umfasst:
Bereitstellen einer geneigten festen Transferschiene;
Bereitstellen mehrerer Abscheidungskammern entlang der geneigten festen Transferschiene;
Bereitstellen einer kreisförmigen Haltevorrichtungs-Trägeranordnung, die dafür ausgelegt ist, wenigstens ein Substrat zu enthalten;
Anordnen des wenigstens einen Substrats in der Haltevorrichtungs-Trägeranordnung; und
Rollen der Haltevorrichtungs-Trägeranordnungen in und zwischen die Abscheidungskammern entlang der geneigten festen Transferschiene unter dem Einfluss der Schwerkraft.

## Revendications

1. Système de dépôt (100) comprenant:
un logement de système (122) ayant un cadre de logement, des panneaux de logement (123, 127, 128) portés par ledit cadre de logement et un intérieur de logement (124);
un ensemble de transfert de dispositif de fixation (146) ayant un rail de transfert de dispositif de fixation (147) incliné généralement allongé porté par le cadre du système et s'étendant au travers de l'intérieur du logement;
une pluralité de chambres de dépôt séquentiellement ordonnées (185) portées par le rail de transfert du dispositif de fixation dans l'intérieur du logement;
un dispositif de commande (222) en interface avec les chambres de dépôt;
une pluralité d'ensembles support de dispositif de fixation circulaires (156) portés par le rail de transfert du dispositif de fixation et adaptés chacun pour contenir un substrat; et
les ensembles support du dispositif de fixation roulant le long du rail de transfert du dispositif de fixation sous l'effet de la gravité.

2. Système de dépôt (100) selon la revendication 1, dans lequel le rail de transfert du dispositif de fixation (147) de l'ensemble de transfert du dispositif de fixation (146) comprend un segment de rampe de chargement (153, 153a) et un segment de rampe de déchargement (154, 154a) s'étendant depuis l'intérieur du logement (124) sur des côtés opposés du logement du système (122).

3. Système de dépôt (100) selon la revendication 1, dans lequel le logement du système (122) comprend au moins une entrée.

4. Système de dépôt (100) selon la revendication 1, dans lequel l'intérieur de logement (124) du logement du système (122) comprend un compartiment de sous-système (125) et un compartiment de chambre (126), et dans lequel les chambres de dépôt sont contenues dans le compartiment de chambre.

5. Système de dépôt selon la revendication 4, dans lequel le logement du système (122) comprend au moins une porte de compartiment de sous-système (130) adaptée pour ouvrir et fermer sélectivement le compartiment de sous-système (125) et au moins une entrée de compartiment de chambre adaptée pour ouvrir et fermer sélectivement le compartiment de chambre.

6. Système de dépôt (100) selon la revendication 5, dans lequel l'au moins une entrée de compartiment de sous-système comprend des première et seconde portes de compartiment de sous-système (130) et l'au moins une entrée de compartiment de chambre comprend des première et seconde entrées de compartiment de chambre.

7. Système de dépôt (100) selon la revendication 1, dans lequel chacun des ensembles support du dispositif de fixation (156) comprend un cadre d'ensemble circulaire (157); ou comprenant en outre une ouverture du dispositif de fixation dans la plaque de montage du dispositif de fixation et dans lequel le substrat est contenu dans l'ouverture du dispositif de fixation; ou dans lequel chacun des dispositifs de fixation du substrat comprend un cadre du dispositif de fixation ayant une ouverture de cadre de dispositif de fixation dimensionnée pour recevoir un substrat; ou comprenant en outre une rainure de rail périphérique dans le cadre d'ensemble (157) et recevant le rail de transfert du dispositif de fixation (147) de l'ensemble de transfert du dispositif de fixation (146); ou dans lequel le rail de transfert du dispositif de fixation (147) de l'ensemble de transfert du dispositif de fixation (146) comprend un segment de rampe de chargement (153, 153a) et un segment de rampe de déchargement (154, 154a) s'étendant depuis l'intérieur du logement (124) sur des côtés opposés du logement du système (122); ou comprenant en outre un système de refroidissement de chambre (236) en interface avec chacune des chambres de dépôt physique en phase vapeur (185) et le dispositif de commande (222).

8. Système de dépôt (100) selon la revendication 1 comprenant en outre une interface homme-machine (224) en interface avec le dispositif de commande (222).

9. Système de dépôt (100) selon la revendication 1, comprenant en outre:
un logement de système généralement carré (122) avec un compartiment de sous-système (125) et un compartiment de chambre (126);
l'ensemble de transfert du dispositif de fixation (146) s'étendant généralement au travers du compartiment de chambre (126) de l'intérieur du logement;
la pluralité de chambres de dépôt séquentiellement ordonnées (185) portées par le rail de transfert du dispositif de fixation (147) dans le compartiment de chambre de l'intérieur du logement;
un dispositif de commande logique programmable (222) en interface avec la chambre de gravure (198) et les chambres de dépôt physique en phase vapeur;
une interface homme-machine en interface avec le dispositif de commande logique programmable;
chacun des ensembles support du dispositif de fixation comprenant: un cadre d'ensemble circulaire;
une plaque de montage du dispositif de fixation portée par le cadre d'ensemble;
une seule ouverture du dispositif de fixation dans la plaque de montage du dispositif de fixation;
une rainure de rail périphérique dans le cadre d'ensemble et recevant le rail de transfert du dispositif de fixation de l'ensemble de transfert du dispositif de fixation; et
les ensembles support du dispositif de fixation sont transférés entre la chambre de gravure et les chambres de dépôt sous l'effet de la gravité.

10. Système de dépôt (100) selon la revendication 9, dans lequel chacun des dispositifs de fixation de substrat comprend un cadre du dispositif de fixation ayant une ouverture de cadre du dispositif de fixation dimensionnée pour recevoir un substrat.

11. Système de dépôt (100) selon la revendication 9, dans lequel chacune des chambres de dépôt (185) est adaptée pour appliquer au moins un revêtement sur chacune des surfaces opposées du substrat.

12. Procédé de dépôt comprenant les étapes consistant à:
fournir un rail de transfert fixe incliné;
fournir une pluralité de chambres de dépôt le long du rail de transfert fixe incliné;
fournir un ensemble support du dispositif de fixation adapté pour contenir au moins un substrat;
placer l'au moins un substrat dans l'ensemble support du dispositif de fixation; et
rouler les ensembles support du dispositif de fixation dans et entre les chambres de dépôt le long du rail de transfert incliné du dispositif de fixation sous l'effet de la gravité.
